# EUROPÄISCHE PATENTSCHRIFT

(11) **EP 0 703 669 B1**
(45) Veröffentlichungstag und Bekanntmachung des Hinweises auf die Patenterteilung: **28.10.1998**
(21) Anmeldenummer: 95113631.6
(22) Anmeldetag: 30.08.1995
(51) Int. Cl.: H03K 17/95, H03K 17/97, E05B 17/22

(54) **Näherungsschalter mit drei Schaltpositionen**
Proximity switch having three switching positions
Commutateur de proximité ayant trois positions de commutation

(30) Priorität: 20.09.1994 DE 9415257 U
(43) Veröffentlichungstag der Anmeldung: 27.03.1996
(73) Patentinhaber: SIEMENS AKTIENGESELLSCHAFT, 80333 München (DE)
(72) Erfinder: Jansseune, Luc, B-8400 Oostende (BE)

(56) Entgegenhaltungen:
- DE-C- 4 211 486

## Beschreibung

Die Erfindung betrifft einen Mikroschalter mit einem integrierten Schaltkreis, der zwei Hall-Sensoren und mindestens eine Auswerteschaltung aufweist, sowie mit einem fest unterhalb der beiden Hall-Sensoren angeordneten Dauermagneten, der mit einem Pol den beiden Hall-Sensoren zugewandt ist und dessen Feldlinien die Hall-Sensoren durchsetzen, wobei das Verhältnis des Magnetflusses in jedem der beiden Hall-Sensoren über die Auswerteschaltung ermittelt und aus einer Änderung dieses Verhältnisses bei Annäherung eines ferromagnetischen Auslösekörpers ein Schaltsignal abgeleitet wird.

Ein derartiger Näherungsschalter ist bereits aus der DE-PS 42 11 486 bekannt. Der dortige Schalter ist jedoch als Ein-Aus-Schalter konzipiert.

Aufgabe der vorliegenden Erfindung ist es, einen Näherungsschalter der eingangs angegebenen Art zu schaffen, durch den der Zustand des Schloßzylinders in einer Kraftfahrzeugtür für die Zentralverriegelung abgefragt werden soll. Es sollen drei Zustände erkannt werden: Schloßzylinder in Ruhe, nach links gedreht oder nach rechts gedreht (Öffnen oder Schließen der Kfz-Türe).

Erfindungsgemäß wird dies dadurch erreicht, daß der Mikroschalter drei Schaltpositionen und eine duale Auswerteschaltung aufweist, die in Reaktion auf eine positive oder negative Magnetflußdifferenz zwischen den beiden Hall-Sensoren ihren Schaltzustand bezüglich eines ersten bzw. zweiten Ausgangs ändert, wobei das Auftreten einer verschwindenden, einer positiven oder einer negativen Magnetflußdifferenz über drei Positionen des Auslösekörpers schaltbar ist.

Für die aufgabengemäße Anwendung ist dieser Schalter dadurch besonders geeignet, daß der Auslösekörper am Schloßzylinder einer Kraftfahrzeugtür befestigt ist, daß sich der Auslösekörper in der Ruhestellung des Schloßzylinders mittig oberhalb der beiden Hall-Sensoren befindet und daß der Auslösekörper durch Drehen des Schloßzylinders in eine außermittige Position gegenüber den beiden Hall-Sensoren bringbar ist, so daß die drei Schaltpositionen des Mikroschalters mit dem in Ruhe befindlichen und dem nach links bzw. recht gedrehten Schloßzylinder korrespondieren.

Die Erfindung wird anhand der Figuren der Zeichnung noch näher erläutert. Es zeigt:
- Figur 1: schematisch den Aufbau des Näherungsschalters,
- Figur 2: die Abhängigkeit des Magnetflusses von der Position des Auslösekörpers,
- Figur 3: ein Schaltungs-Blockdiagramm für eine bei einem erfindungsgemäßen Schalter verwendbare duale Auswerteschaltung.

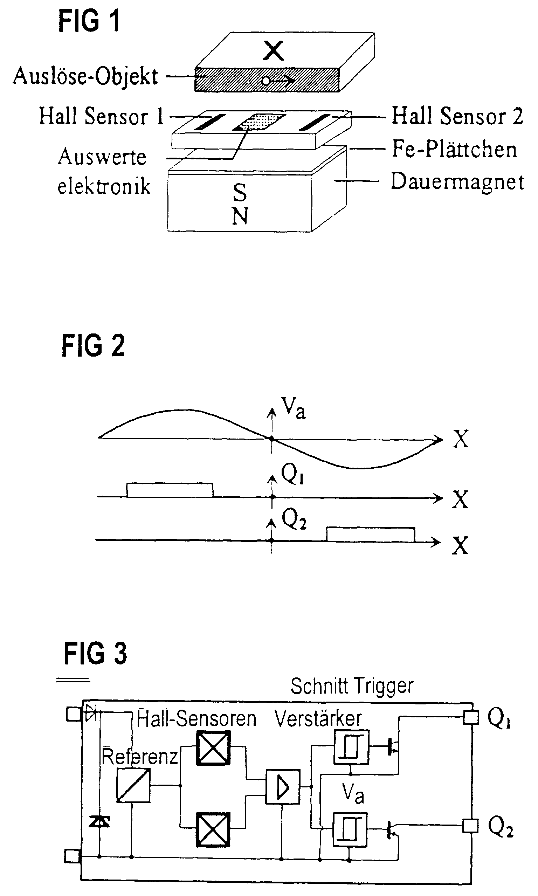

Die wesentlichen Bestandteile des Näherungsschalters sind in Figur 1 dargestellt.

Wie bei Zahnradsensoren ist ein Hall-Differenz-IC oberhalb einem Magnet mit Homogenisierungsblech angebracht. Am Schloßzylinder ist ein ferromagnetisches Objekt (z.B. Stanzblech) befestigt und befindet sich in Ruhestellung (= Mittelstellung), mittig oberhalb beider Hall-Generatoren. Wird am Schloßzylinder gedreht, dann wird der Auslöseteil in außermittige Position gegenüber dem Hall-Differenz-IC bewegt (x<>0). In dieser Position wird eine Magnetflußdifferenz zwischen den beiden Hall-Generatoren wahrgenommen. Davon abhängig, ob der Auslöseteil außermittig links oder rechts steht, ist die Magnetflußdifferenz positiv oder negativ, wie in Figur 2 dargestellt. Um diese Links- und Rechtsposition auswerten zu können, muß der IC mit 2 Schmitt-Triggern und 2 Ausgangsstufen versehen werden, wie es in Figur 3 dargestellt ist.

Mit dem erfindungsgemäßen Näherungsschalter mit drei Schaltpositionen können Schaltabstände bis 3,5 mm realisiert werden.

## Patentansprüche

1. Mikroschalter mit einem integrierten Schaltkreis, der zwei Hall-Sensoren und mindestens eine Auswerteschaltung aufweist, sowie mit einem fest unterhalb der beiden Hall-Sensoren angeordneten Dauermagneten, der mit einem Pol den beiden Hall-Sensoren zugewandt ist und dessen Feldlinien die Hall-Sensoren durchsetzen, wobei das Verhältnis des Magnetflusses in jedem der beiden Hall-Sensoren über die Auswerteschaltung ermittelt und aus einer Änderung dieses Verhältnisses bei Annäherung eines ferromagnetischen Auslösekörpers ein Schaltsignal abgeleitet wird,
**dadurch gekennzeichnet**, daß der Mikroschalter drei Schaltpositionen und eine duale Auswerteschaltung aufweist, die in Reaktion auf eine positive oder negative Magnetflußdifferenz zwischen den beiden Hall-Sensoren ihren Schaltzustand bezüglich eines ersten bzw. zweiten Ausgangs ändert, wobei das Auftreten einer verschwindenden, einer positiven oder einer negativen Magnetflußdifferenz über drei Positionen des Auslösekörpers schaltbar ist.

2. Mikroschalter nach Anspruch 1,
**dadurch gekennzeichnet**, daß der Auslösekörper am Schloßzylinder einer Kraftfahrzeugtür befestigt ist, daß sich der Auslösekörper in der Ruhestellung des Schloßzylinders mittig oberhalb der beiden Hall-Sensoren befindet und daß der Auslösekörper durch Drehen des Schloßzylinders in eine außermittige Position gegenüber den beiden Hall-Sensoren bringbar ist, so daß die drei Schaltpositionen des Mikroschalters mit dem in Ruhe befindlichen und dem nach links bzw. recht gedrehten Schloßzylinder korrespondieren.

## Claims

1. Microswitch having an integrated circuit which has two Hall sensors and at least one evaluation circuit, and having a permanent magnet which is arranged fixedly below the two Hall sensors, faces the two Hall sensors with one pole and whose field lines penetrate the Hall sensors, the ratio of the magnetic flux in each of the two Hall sensors being determined via the evaluation circuit, and a switching signal being derived from a change in this ratio when a ferromagnetic trigger member approaches, characterized in that the microswitch has three switching positions and a dual evaluation circuit which, in reaction to a positive or negative difference in magnetic flux between the two Hall sensors, changes its switching state with reference to a first or second output, the occurrence of a vanishing, a positive or a negative difference in magnetic flux being switchable via three positions of the trigger member.

2. Microswitch according to Claim 1, characterized in that the trigger member is fastened to the lock cylinder of a motor vehicle door, in that in the rest position of the lock cylinder the trigger member is located in the middle above the two Hall sensors, and in that by rotating the lock cylinder the trigger member can be brought into an eccentric position with respect to the two Hall sensors, with the result that the three switching positions of the microswitch correspond to the lock cylinder located at rest and turned to the left or the right.

## Revendications

1. Commutateur miniature avec un circuit intégré, comprenant deux capteurs à effet Hall et au moins un circuit d'analyse, ainsi qu'un aimant permanent fixé sous les deux capteurs à effet Hall, dont un des pôles est tourné vers les deux capteurs à effet Hall et dont les lignes de champ traversent les capteurs à effet Hall, le rapport du flux magnétique dans chacun des deux capteurs à effet Hall étant déterminé par le biais du circuit d'analyse et un signal de commutation étant dérivé à partir d'un changement de ce rapport à l'approche d'un corps de déclenchement ferromagnétique, caractérisé en ce que le commutateur miniature comprend trois positions de commutation et un circuit d'analyse binaire qui, en réaction à une différence de flux magnétique positive ou négative entre les deux capteurs à effet Hall, modifie son état de commutation par rapport à une première resp. seconde sortie, la disparition d'une différence de flux magnétique ou l'apparition d'une différence de flux magnétique positive ou négative reflétant le passage par trois positions du corps de déclenchement.

2. Commutateur miniature selon la revendication 1, caractérisé en ce que le corps de déclenchement est fixé sur le barillet d'une porte de véhicule automobile, en ce que le corps de déclenchement occupe, dans la position de repos du barillet, une position centrale au-dessus des deux capteurs à effet Hall, et en ce que le corps de déclenchement peut être amené dans une position excentrique par rapport aux deux capteurs à effet Hall sous l'effet de la rotation du barillet, de manière à ce que les trois positions de commutation du commutateur miniature correspondent au barillet au repos et au barillet tourné sur la gauche resp. sur la droite.
